(19) Europäisches Patentamt / European Patent Office / Office européen des brevets

(11) **EP 2 758 795 B1**

(12) **FASCICULE DE BREVET EUROPEEN**

(45) Date de publication et mention de la délivrance du brevet:
**21.03.2018 Bulletin 2018/12**

(21) Numéro de dépôt: **12759741.7**

(22) Date de dépôt: **19.09.2012**

(51) Int Cl.:
*G01S 5/22* $^{(2006.01)}$          *G01R 31/02* $^{(2006.01)}$

(86) Numéro de dépôt international:
**PCT/EP2012/068441**

(87) Numéro de publication internationale:
**WO 2013/041566 (28.03.2013 Gazette 2013/13)**

(54) **PROCÉDÉ DE LOCALISATION D'UN ÉVÈNEMENT ÉMETTANT UN SIGNAL**

VERFAHREN ZUR ORTUNG EINES SIGNALÜBERTRAGENDEN EREIGNISSES

METHOD OF LOCATING AN EVENT TRANSMITTING A SIGNAL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **20.09.2011 FR 1158365**

(43) Date de publication de la demande:
**30.07.2014 Bulletin 2014/31**

(73) Titulaire: **General Electric Technology GmbH 5400 Baden (CH)**

(72) Inventeur: **LEBRETON, Raphaël F-91300 Massy (FR)**

(74) Mandataire: **Cleary, Fidelma et al Global Patent Operation - Europe GE International Inc. The Ark 201 Talgarth Road Hammersmith London W6 8BJ (GB)**

(56) Documents cités:
**US-A- 5 166 694**

- **LUO RI-CHENG ET AL: "Study on Partial Discharge Localization by Ultrasonic Measuring in Power Transformer Based on Particle Swarm Optimization", HIGH VOLTAGE ENGINEERING AND APPLICATION, 2008. ICHVE 2008. INTERNATIONAL CONFERENCE ON, IEEE, PISCATAWAY, NJ, USA, 9 novembre 2008 (2008-11-09), pages 600-603, XP031418308, ISBN: 978-1-4244-3823-5**
- **SU SU WIN ET AL: "Partial discharge detection and localization in power transformers", ELECTRICAL ENGINEERING/ELECTRONICS, COMPUTER, TELECOMMUNICATIONS AND INFORMATION TECHNOLOGY (ECTI-CON), 2011 8TH INTERNATIONAL CONFERENCE ON, IEEE, 17 mai 2011 (2011-05-17), pages 673-676, XP032002225, DOI: 10.1109/ECTICON.2011.5947929 ISBN: 978-1-4577-0425-3**
- **James Bao-Yen Tsui: "Fundamentals of Global Positioning System Receivers: A Software Approach", , 27 janvier 2005 (2005-01-27), pages 7-31, XP055027887, ISBN: 978-0-47-138154-9 Extrait de l'Internet: URL:http://onlinelibrary.wiley.com/store/1 0.1002/0471200549.ch2/asset/ch2.pdf?v=1&t= h2k3w3w4&s=5e813ae0c868475a8e38617b9a45 6fc cfe861f7c [extrait le 2012-05-23]**

EP 2 758 795 B1

**Description**

**DOMAINE TECHNIQUE**

La présente invention concerne un procédé utilisant un ensemble de capteurs pour localiser un évènement émettant un signal. Le signal peut être un signal acoustique, un signal électromagnétique tel qu'un signal radioélectrique ou encore un signal électromécanique tel qu'une vibration provenant d'un organe électromécanique d'un appareil électrique. L'évènement à localiser peut être par exemple une décharge partielle dans un appareil électrique, l'activation d'une source vocale dans un espace, une transitoire de pression dans un pipeline ou autre.

La présente invention est utilisable notamment dans les procédés de détection et de localisation de défauts ou de sources de décharges partielles dans un appareil électrique ou enceinte close tel qu'un transformateur de puissance ou un disjoncteur isolé au gaz. Les décharges partielles dans les appareils électriques sont associées à l'émission d'un signal acoustique (généralement ultrasonore) ou électromagnétique.

Cette application aux appareils électriques n'est pas limitative, bien d'autres applications pourraient être concernées par exemple dans le domaine du sonar, ou la localisation d'une source vocale dans un espace, la surveillance des pipelines, etc.

**ÉTAT DE LA TECHNIQUE ANTÉRIEURE**

La méthode conventionnelle de localisation d'une source d'un signal consiste à mesurer des temps de réponse du signal par un ensemble de capteurs et de résoudre un système d'équations définissant les distances entre les capteurs et la source en fonction des temps de réponse mesurés par les capteurs. La solution du système d'équations donne la position de la source du signal.

Le document LUO ET AL, "Study on Partial Discharge Localization by Ultrasonic Measuring in Power Transformer Based on Particle Swarm Optimization", Proc. of Int. Conf. on High Voltage Engineering and Application, 2008, par exemple décrit un procédé de localisation d'une source d'un signal au moyen de mesures des temps de réponse du signal par un ensemble de capteurs et une résolution d'un système d'équations définissant des distances entre les capteurs et la source du signal. Dans le cas où le système d'équations n'a pas de solution, la méthode conventionnelle propose de changer la position des capteurs pour obtenir un meilleur signal avant de refaire les calculs et de recommencer les déplacements et les calculs jusqu'à ce qu'on trouve une solution au système d'équations.

Cependant, il y a des cas où on ne pourrait pas déplacer les capteurs, particulièrement pour les capteurs à ultra haute fréquence UHF. De plus, il y a des cas où la source serait difficile à trouver même en déplaçant les capteurs et en particulier pour des capteurs à temps de réponse très court ou pas assez précis ou pour une recherche d'émission en milieu sévère avec par exemple des obstacles pouvant retarder ou affaiblir le signal.

L'objet de la présente invention est par conséquent de proposer un système et un procédé de localisation d'un évènement émettant un signal, ne présentant pas les inconvénients précités et en particulier en s'affranchissant de la nécessité de déplacer les capteurs.

**EXPOSÉ DE L'INVENTION**

La présente invention est définie par un procédé de localisation d'un évènement émettant un signal, comportant une mesure des temps de réponse dudit signal par un ensemble de capteurs, et une résolution d'un système d'équations définissant des distances entre lesdits capteurs et ledit évènement en fonction d'une vitesse de propagation dudit signal et d'un décalage desdits temps de réponse par rapport à un temps de référence. Dans le cas où le système d'équations ne présente pas de solution indiquant la position de l'évènement, le procédé comporte les étapes suivantes :

- relancer une pluralité de fois la résolution du système d'équations en modifiant à chaque itération le temps de réponse d'au moins un desdits capteurs selon une augmentation ou une diminution dudit temps de réponse par un pourcentage inférieur à une valeur déterminée, la résolution dudit système d'équations étant relancée à chaque itération jusqu'à ce que la somme pour chacun des capteurs, des différentes augmentations ou diminutions dudit temps de réponse par un pourcentage inférieur à une valeur déterminée qui ont engendré des solutions soit proche de zéro, et
- déterminer la localisation de l'évènement en calculant la moyenne des solutions obtenues lors des résolutions dudit système d'équations.

Ce procédé permet de donner de manière simple une solution alternative à une localisation qui n'aurait pas de points d'intersection par une méthode traditionnelle. Cet avantage est notamment très intéressant dans le cas où on ne pourrait pas déplacer les capteurs ou alors dans le cas où la position de l'évènement serait difficile à trouver même en déplaçant les capteurs. En outre, ce procédé permet d'obtenir la zone dans laquelle se situe l'évènement avec un nombre minimal de capteurs. En outre, le procédé permet de donner une très bonne approximation de la localisation de l'évènement. De plus, l'implémentation du procédé est facilitée en variant le pourcentage par exemple, de manière aléatoire pour s'affranchir de toute solution a priori et pour permettre une moyenne de variation proche de zéro.

Ladite valeur déterminée peut être de l'ordre de 30% et de préférence de 15%.

Une augmentation ou une diminution du temps de réponse par un pourcentage compris entre 0% et 15% permet de déterminer la localisation de l'évènement avec une grande précision. Par ailleurs, on peut opérer une variation comprise entre 0% et 30% dans le cas où aucun résultat ne serait trouvé ou si le nombre de systèmes d'équations convergeant serait trop faible.

Avantageusement, la résolution du système d'équations est relancée à chaque itération jusqu'à ce que la somme pour chacun des capteurs, des différentes variations locales du temps de réponse qui ont engendré des solutions, soit inférieure à 2% et de préférence inférieure à 1%.

Une somme de variations locales proche de zéro permet d'augmenter la précision de la localisation de l'évènement du signal.

Dans le cas où la date d'émission dudit signal est inconnue, le temps de référence selon un premier mode de réalisation correspond à un temps de réponse minimal mesuré par l'un des capteurs dudit ensemble de capteurs, et dans le cas où la date d'émission dudit signal est connue, le temps de référence selon un deuxième mode de réalisation correspond à ladite date d'émission.

Avantageusement, les capteurs sont positionnés selon un repère de coordonnées bidimensionnelles ou tridimensionnelles de manière à ce que pour au moins un nombre minimal déterminé de capteurs, chaque capteur a au plus une seule coordonnée en commun avec un seul autre capteur.

Ceci permet d'augmenter la précision de la solution.

Dans le cas où la date d'émission du signal est inconnue, l'ensemble de capteurs comporte un nombre de capteurs strictement supérieur au nombre de coordonnées, et dans le cas où la date d'émission dudit signal est connue, l'ensemble de capteurs comporte un nombre de capteurs supérieur ou égal au nombre de coordonnées. Ainsi, dans un repère tridimensionnel, l'ensemble de capteurs comporte au moins trois capteurs dans le cas où la date d'émission du signal est connue et au moins quatre capteurs dans le cas contraire.

L'invention vise également un dispositif de localisation d'un évènement émettant un signal, comportant :

- un ensemble de capteurs pour mesurer des temps de réponse dudit signal,
- des moyens de traitement pour résoudre un système d'équations définissant des distances entre lesdits capteurs et ledit évènement en fonction d'une vitesse de propagation dudit signal et d'un décalage desdits temps de réponse par rapport à un temps de référence,
- des moyens de traitement pour relancer une pluralité de fois la résolution du système d'équations en modifiant à chaque fois le temps de réponse d'au moins un desdits capteurs selon une augmentation ou une diminution dudit temps de réponse par un pourcentage inférieur à une valeur déterminée, la résolution dudit système d'équations étant relancée à chaque itération jusqu'à ce que la somme pour chacun des capteurs, des différentes augmentations ou diminutions dudit temps de réponse par un pourcentage inférieur à une valeur déterminée qui ont engendré des solutions soit proche de zéro, et
- des moyens de traitement pour déterminer la localisation de l'évènement en calculant la moyenne des solutions obtenues lors des résolutions dudit système d'équations.

Avantageusement, l'ensemble de capteurs comporte des capteurs à ultra haute fréquence et/ou des capteurs à ultrasons.

L'invention vise aussi un programme d'ordinateur comportant des instructions pour la mise en oeuvre du procédé de localisation selon l'une quelconque des caractéristiques ci-dessus lorsqu'il est exécuté par des moyens de traitement.

## BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :

la Fig. 1 représente de manière schématique un dispositif de localisation d'un évènement émettant un signal prenant naissance dans un objet quelconque à surveiller, selon l'invention ;
la Fig. 2 représente de manière schématique un dispositif de localisation d'une source prenant naissance dans un appareil électrique, selon l'invention ;
la Fig. 3 illustre l'intersection des sphères représentant la solution d'un système d'équations définissant les relations entre les positions des capteurs et la position de l'évènement émettant un signal ;
la Fig. 4 représente de manière schématique un dispositif de localisation d'un signal, comportant quatre capteurs pour illustrer le cas où la date d'émission du signal est inconnue, selon l'invention ;
la Fig. 5 représente de manière schématique un dispositif de localisation d'un signal, comportant des moyens électriques pour mesurer la date d'émission du signal, selon l'invention ; et
la Fig. 6 illustre des résultats trouvés lors de la résolution du système d'équations selon la présente invention.

## EXPOSÉ DÉTAILLÉ DE MODES DE RÉALISATION PARTICULIERS

Le principe de base de la présente invention est de modifier les temps de réponse des capteurs par des variations locales autour de leurs valeurs initiales.

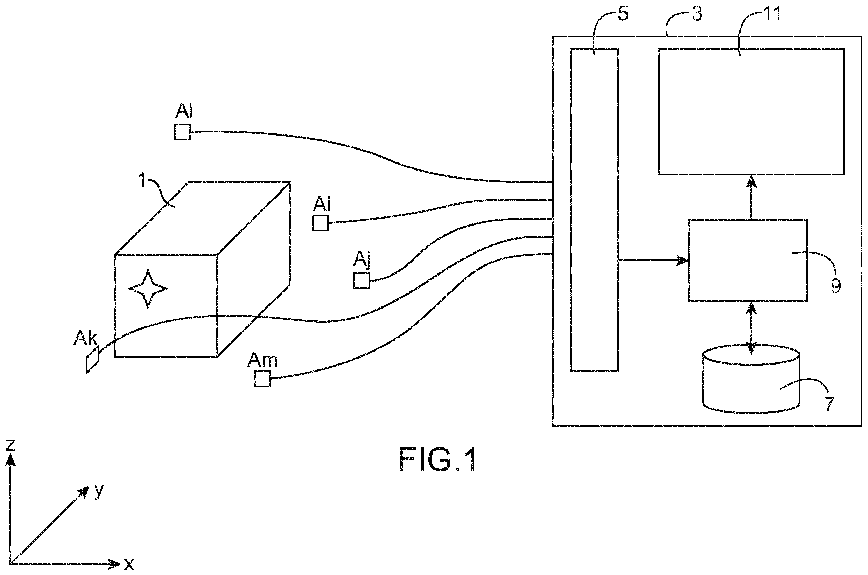

La Fig. 1 représente de manière schématique un dispositif ou système de localisation d'un évènement émettant un signal prenant naissance dans un objet quelconque à surveiller, selon l'invention.

Le système de localisation comporte un ensemble de capteurs $A_i$-$A_m$ placés autour de l'objet 1 à surveiller et connectés à des moyens de traitement 3 de signaux.

On notera que le dispositif ou système de localisation selon l'invention peut être utilisé dans un espace bidimensionnel ou tridimensionnel. Par exemple, le dispositif peut être utilisé pour chercher à localiser la source émettrice d'un signal au sol ou sur une surface et dans ce cas, les capteurs sont disposés sur la surface selon un repère de coordonnées bidimensionnelles. Selon un autre exemple, le système peut être utilisé pour chercher à localiser un signal prenant naissance dans un objet tridimensionnel et dans ce cas, les capteurs peuvent être disposés autour de cet objet selon un repère de coordonnées tridimensionnelles.

Avantageusement, afin d'augmenter la précision de la localisation, les capteurs $A_i$-$A_m$ sont positionnés de sorte que pour au moins un nombre minimal déterminé de capteurs, chaque capteur a au plus une seule coordonnée en commun avec un seul autre capteur. Autrement dit, chaque capteur n'a pas plus d'une coordonnée en commun avec chacun des autres capteurs et il n'y a pas plus de deux capteurs ayant la même coordonnée. Le nombre minimal déterminé de capteurs peut être égal à trois ou quatre selon la dimension de l'espace, les types de capteurs, ou la configuration du dispositif de localisation.

Les capteurs peuvent être des détecteurs à ultrasons "US" ou à ultra haute fréquence "UHF" et sont configurés pour mesurer des temps de réponse d'un signal émis par l'évènement S (représenté par une petite étoile) dont la localisation est recherchée. On notera que le temps de réponse d'un signal signifie le temps de réception du signal par le capteur.

Les moyens de traitement 3 comportent des moyens d'acquisition 5, des moyens de stockage 7, des moyens de calcul 9 et des moyens de sortie 11 comprenant par exemple des moyens d'affichage 13. Les moyens d'acquisition 5 sont configurés pour acquérir et numériser les mesures réalisées par les capteurs. Les moyens de calcul 9 en association avec les moyens de stockage 7 sont configurés pour résoudre un système d'équations définissant des distances entre les capteurs $A_i$-$A_m$ et l'évènement S en fonction de la vitesse de propagation du signal et d'un décalage des temps de réponse par rapport à un temps de référence. Le temps de référence peut correspondre à la date d'émission du signal ou à un temps de réponse d'un autre capteur par rapport auquel sont définis les autres temps de réponses.

On notera que les moyens de stockage 7 peuvent comprendre un programme d'ordinateur comprenant des instructions de code pour la mise en oeuvre du procédé de localisation selon l'invention lorsque le programme d'ordinateur est exécuté par les moyens de traitement 3.

Conformément à l'invention, dans le cas où le système d'équations ne présente pas de solution indiquant la position de l'évènement S, les moyens de traitement 3 sont configurés pour relancer une pluralité de fois la résolution du système d'équations en modifiant à chaque fois le temps de réponse d'au moins un des capteurs selon une variation locale. On entend par variation locale, une variation relativement faible au voisinage de la valeur initiale du temps de réponse. Avantageusement, la somme des variations est asymptotiquement nulle.

En outre, les moyens de traitement 3 sont configurés pour déterminer par une méthode statistique la localisation de l'évènement S en fonction des positions obtenues lors des différentes résolutions du système d'équations.

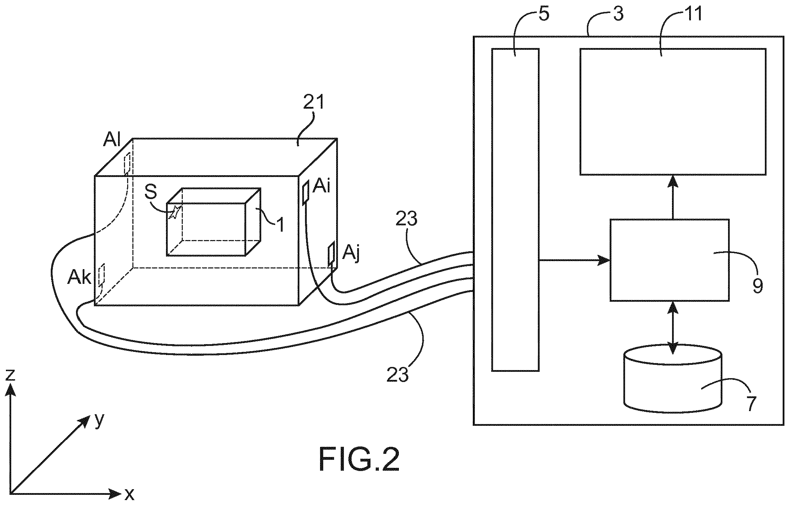

La Fig. 2 représente de manière schématique un dispositif de localisation d'une source prenant naissance dans un appareil électrique, selon l'invention.

Cet appareil électrique 1 correspond par exemple, à un transformateur de puissance qui est généralement composé d'une enceinte ou cuve 21 contenant un fluide diélectrique tel que de l'huile ou de l'hexafluorure de soufre.

On place un ensemble de capteurs $A_i$-$A_l$ autour de l'appareil électrique 1 pour détecter la position d'un signal correspondant à la survenue d'un évènement S recherché, par exemple, l'instant d'apparition d'une décharge partielle prenant naissance dans l'appareil électrique 1.

On peut utiliser des capteurs à ultrasons US ou des capteurs à ultra haute fréquence UHF. Les capteurs à ultrasons sont des capteurs piézoélectriques qui peuvent être posés sur la cuve 21 qui compose l'appareil électrique 1. Ces capteurs US positionnés sur une ou plusieurs parois de la cuve 21, perçoivent les ondes acoustiques ou vibrations produites par les décharges émanant de l'appareil électrique 1. Les temps de réponse des capteurs US sont de l'ordre de la milliseconde.

En variante, les capteurs à ultra haute fréquence UHF sont des capteurs qui détectent les ondes électromagnétiques. On notera qu'en général la cuve 21 est en acier et ne laisse pas passer les ondes électromagnétiques. Ainsi, les capteurs UHF peuvent être insérés dans la cuve 21 via par exemple une vanne (non représentée) et/ou peuvent être posés contre une vitre (par exemple, en nylon, téflon ou autre matière non métallique) de la cuve 21. Les capteurs UHF ont un temps de réponse de l'ordre de la nano seconde et donc peuvent recevoir des signaux 1000 fois plus rapides que les capteurs US.

Avantageusement, les capteurs $A_i$-$A_l$ sont positionnés de manière à être espacés le plus loin possible les uns des autres et de sorte qu'ils n'aient pas deux coordonnées en commun deux-à-deux. Ainsi, pour faciliter et augmenter la précision de la solution, il est avantageux, autant que possible de ne pas placer les capteurs ni à la même hauteur $z$, ni à la même abscisse $x$, et ni à la même ordonnée $y$. En particulier, dans l'exemple de la Fig. 2 les quatre capteurs $A_i$-$A_l$ n'ont que deux coordonnées en commun deux à deux. Par exemple, les capteurs $A_i$ et $A_j$ peuvent avoir la même abscisse, les capteurs $A_i$ et $A_k$ la même hauteur, les capteurs $A_j$ et $A_k$ la même ordonnée, les capteurs $A_j$ et $A_l$ la même hauteur, les capteurs $A_k$ et $A_l$ la même abscisse et les autres coordonnées sont différentes. De plus, les capteurs sont disposés assez proches des bords de l'enceinte tout en n'ayant pas de coordonnées minimales ou maximales afin de préserver la bonne sensibilité en réception des capteurs. Bien entendu, un plus grand nombre de capteurs permet d'améliorer la localisation de l'évènement. Les coordonnées $(x_i, y_i, z_i)$, $(x_j, y_j, z_j)$, $(x_k, y_k, z_k)$ et $(x_l, y_l, z_l)$ de l'ensemble des capteurs peuvent être enregistrées dans les moyens de stockage 7.

La référence S illustre une source de décharge partielle correspondant à l'évènement recherché. Ainsi, à l'apparition de cette décharge partielle les capteurs $A_i$, $A_j$, $A_k$, et $A_l$ mesurent les temps de réponse $t_i$, $t_j$, $t_k$, et $t_l$ respectivement du signal émis par cet évènement. Plus particulièrement, les signaux acquis par les capteurs $A_i$-$A_l$ sont transmis via des câbles de liaisons 23 aux moyens de traitement 3 qui va traiter ces signaux pour déterminer et afficher les temps de réponses.

Les coordonnées $(x_i, y_i, z_i)$, $(x_j, y_j, z_j)$, $(x_k, y_k, z_k)$, $(x_l, y_l, z_l)$ des capteurs $A_i$-$A_l$ et leurs temps de réponse $t_i$-$t_l$ ainsi que la vitesse de propagation $v$ du signal dans le milieu considéré permettent aux moyens de traitement 3 de définir un système d'équations dont la solution représente la position de l'évènement S. Le système d'équations définit les distances entre les capteurs $A_i$-$A_l$ et l'évènement S en fonction de la vitesse de propagation $v$ du signal et d'un décalage des temps de réponse par rapport à un temps de référence.

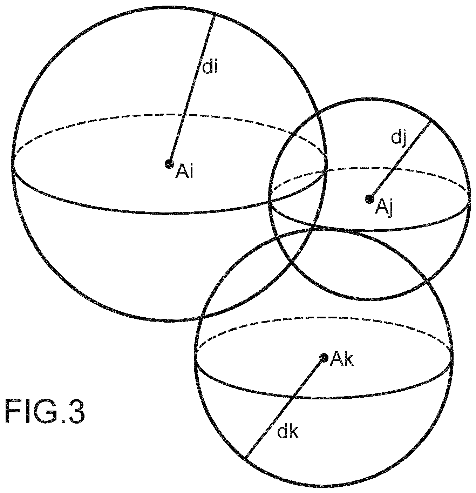

En effet, dans un espace tridimensionnel, chaque équation correspond à celle d'une sphère et la solution du système d'équations consiste à déterminer le point commun entre les différentes sphères. Ceci est illustré sur la Fig. 3 dans le cadre d'un dispositif de localisation comportant trois capteurs $A_i$, $A_j$ et $A_k$. Supposons que $t_0$ est le temps auquel est émis le signal et $t_i$, $t_j$, $t_k$ les temps de réponse ou de réception des capteurs $A_i$-$A_k$. Ainsi, pour une vitesse de propagation $v$ du signal dans le milieu environnant, le système d'équations des distances $d_i$, $d_j$, et $d_k$ entre les capteurs et la source du signal peut être défini de la forme suivante :

$$d_i = (t_i - t_0)v$$

$$d_j = (t_j - t_0)v$$

$$d_k = (t_k - t_0)v$$

Ainsi, si les temps de réponse et la vitesse de propagation $v$ sont connus, on peut alors déterminer l'intersection entre des sphères (ou cercles dans le cas d'un espace bidimensionnel) ayant pour centres les positions des capteurs $A_i$-$A_k$ et pour rayons les distances $d_i$-$d_k$ parcourues par l'onde pendant les temps de réponses mesurés.

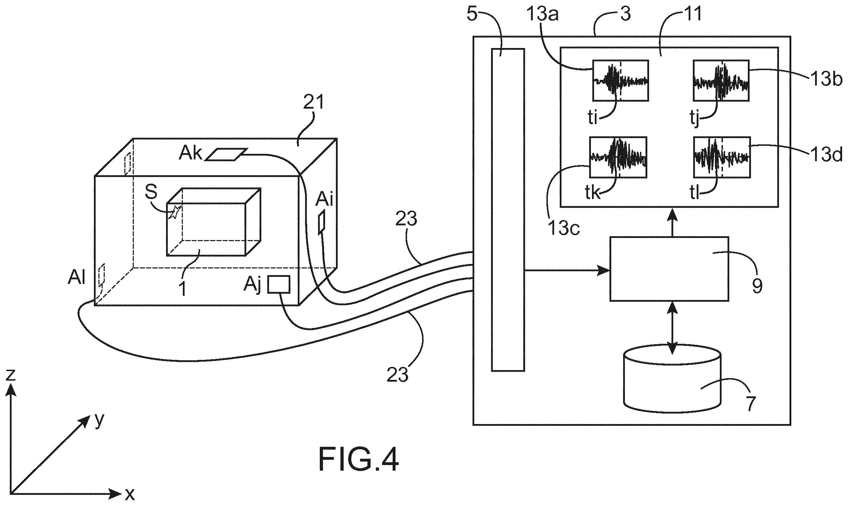

La Fig. 4 représente de manière schématique un dispositif de localisation d'un signal, comportant quatre capteurs pour illustrer le cas où la date d'émission du signal est inconnue.

Dans le cas où la date d'émission du signal est inconnue, le temps de référence correspond au temps de réponse minimal mesuré par l'un des capteurs d'un ensemble comportant au moins quatre capteurs. Autrement dit, le capteur le plus proche de la source S du signal, celui dont le temps de réponse est le plus court, devient le capteur de référence.

Selon cet exemple, quatre capteurs $A_i$, $A_j$, $A_k$, et $A_l$ sont disposés autour de l'appareil électrique 1. Ces capteurs sont connectés via les câbles de liaisons 23 aux moyens de traitement 3. Les signaux et les temps de réponses peuvent être affichés sur des moyens d'affichages 13a-13d compris dans les moyens de sortie 11.

Supposons que dans cet ensemble de quatre capteurs $A_i$-$A_l$, le capteur $A_l$ présente le temps de réponse le plus court et par conséquent, le capteur de référence correspond dans ce cas au capteur $A_l$ (c'est-à-dire, $A_{ref}=A_l$, $x_{ref}=x_l$, $y_{ref}=y_l$, $z_{ref}=z_l$ et $t_{ref}=t_l$). Alors pour une source localisée en un point (x, y, z) à rechercher, le système d'équations est de la forme :

$$f_i - f_{ref} - v^2 (t_i - t_{ref})^2 = 0$$

$$f_j - f_{ref} - v^2 (t_j - t_{ref})^2 = 0$$

$$f_k - f_{ref} - v^2 (t_k - t_{ref})^2 = 0$$

avec :

$$f_{ref} = (x - x_{ref})^2 - (y - y_{ref})^2 - (z - z_{ref})^2$$

$$f_i = (x - x_i)^2 + (y - y_i)^2 + (z - z_i)^2$$

$$f_j = (x - x_j)^2 + (y - y_j)^2 + (z - z_j)^2$$

$$f_k = (x - x_k)^2 + (y - y_k)^2 + (z - z_k)^2.$$

On notera que dans le cas où on utilise des capteurs UHF, il est avantageux d'utiliser des câbles de liaisons 23 de même longueur car la vitesse de propagation du signal dans les câbles en provenance des capteurs n'est plus négligeable. Ceci permet d'éviter de calculer le délai induit par la propagation du signal dans ces câbles 23 puisque du coup c'est le même pour les quatre capteurs.

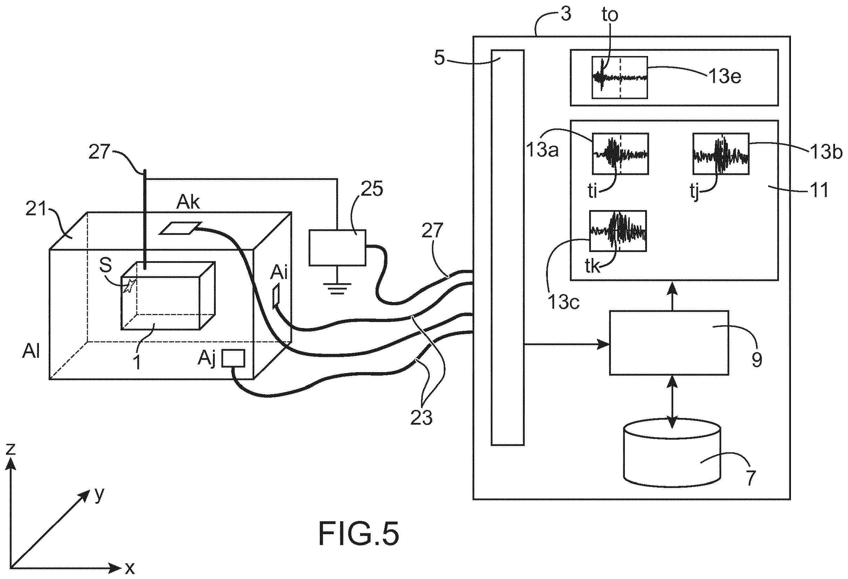

La Fig. 5 représente de manière schématique un dispositif de localisation d'un signal, comportant des moyens électriques pour mesurer la date d'émission du signal.

Dans le cas où la date d'émission $t_0$ est connue, la date de référence correspond à cette date d'émission $t_0$ et il suffit alors que l'ensemble de capteurs comporte au moins trois capteurs.

Selon cet exemple, trois capteurs $A_i$, $A_j$, et $A_k$ sont disposés autour de l'appareil électrique 1 et sont connectés via trois câbles de liaisons 23 aux moyens de traitement 3. Les signaux et temps de réponses sont représentés sur les moyens d'affichage 13a-13c. Le dispositif de localisation comporte également des moyens électriques comprenant un détecteur de décharge 25. Le détecteur de décharge 25 est relié d'une part à une prise capacitive 27 de l'appareil électrique 1 et d'autre part aux moyens de traitement 3 via un câble de mesure 27. La mesure électrique via la prise capacitive 27 permet aux moyens de traitement 3 de déterminer la date d'émission $t_0$ du signal qui est représenté sur le moyen d'affichage 13e.

On notera que le temps de propagation du signal électrique dans le câble de mesure 27 est inconnu et n'est plus négligeable devant la vitesse de réponse des capteurs $A_i$-$A_k$. Par conséquent, on ne peut se servir dans ce cas, que des capteurs de types US qui ne présentent pas des vitesses de réponses relativement élevées.

Ainsi, dans le cas où l'ensemble de capteurs comporte seulement trois capteurs $A_i$, $A_j$, $A_k$, le système d'équations correspondant est défini de la manière suivante :

$$(x - x_i)^2 + (y - y_i)^2 + (z - z_i)^2 - v^2 (t_i - t_0)^2 = 0$$

$$(x - x_j)^2 + (y - y_j)^2 + (z - z_j)^2 - v^2 (t_j - t_0)^2 = 0$$

$$(x - x_k)^2 + (y - y_k)^2 + (z - z_k)^2 - v^2 (t_k - t_0)^2 = 0$$

Il arrive que pour diverses raisons, le système d'équations ne présente pas de solution ou autrement dit, les sphères définies par ces équations ne présentent pas un point commun. Par exemple, une prise de temps peu précise pour des raisons de méconnaissance de l'utilisateur, un signal bruité, un échantillonnage insuffisant du signal, une approximation hasardeuse de l'utilisateur, ou bien d'autres défauts, peuvent compromettre l'intersection des sphères (ou celle des cercles dans le cas d'un espace bidimensionnel) dont on cherche à résoudre l'égalité.

Toutefois, malgré l'absence de solution du système d'équations, la présente invention permet dans un espace bidimensionnel ou tridimensionnel de trouver une solution en modifiant plusieurs fois les temps de réponse des capteurs et en relançant à chaque fois la résolution du système d'équations.

Ainsi, dans le cas où le système d'équations, dans un espace bidimensionnel ou tridimensionnel avec une date d'émission du signal connue ou inconnue, n'a pas de solution, les moyens de traitement 3 relancent une pluralité de fois la résolution du système d'équations en modifiant à chaque fois le temps de réponse d'au moins un des capteurs $A_i$-$A_l$ par une variation locale.

Plus particulièrement, lorsque l'on rencontre un de ces systèmes d'équations et qu'il n'a pas de solution, alors les moyens de traitement modifient le temps de réponse d'au moins un des capteurs par une variation locale correspondant à une augmentation ou une diminution du temps de réponse par un pourcentage inférieur à une valeur déterminée n% qui peut être de l'ordre de 30% et de préférence de l'ordre 15%.

En pratique, ceci peut être réalisé en ajoutant un nouveau paramètre « delta $\Delta$ » à la partie du décalage temporel (c'est-à-dire, le décalage du temps de réponse par rapport au temps de référence) correspondant au capteur. Ce delta $\Delta$ est calculé en fonction de la valeur du temps de réponse correspondant afin de rester dans le même ordre de grandeur.

Le système d'équations est ensuite recalculé une pluralité de fois en intégrant ce nouveau paramètre avec à chaque fois un delta $\Delta$ différent. Avantageusement, on peut imposer que la somme de ces deltas soit nulle ou proche de zéro pour chacun des capteurs. On peut calculer ces deltas en utilisant une variable n qu'on changera à chaque itération p (c'est-à-dire à chaque calcul du système d'équations). De préférence, la variable n peut varier entre 0 et 15 mais peut être supérieure dans le cas où aucun résultat ne serait trouvé avec ces valeurs ou si le nombre de systèmes d'équations convergeant serait trop faible.

Afin d'avoir la valeur des deltas en pourcentage des valeurs initiales des temps de réponses des capteurs, on peut par exemple calculer les deltas à l'itération p de la manière suivante :

$$\Delta_{ip} = \pm(nt_i)/100$$

$$\Delta_{jp} = \pm(nt_j)/100$$

$$\Delta_{kp} = \pm(nt_k)/100$$

$$\Delta_{lp} = \pm(nt_l)/100$$

Avantageusement, afin de s'affranchir de toute solution a priori et pour permettre une moyenne de variation proche de zéro, le calcul des deltas peut être réalisé selon une méthode aléatoire.

Ainsi, pour trois capteurs $A_i$-$A_k$ avec la date d'émission du signal connue, le système d'équations à l'itération p devient :

$$(x-x_i)^2 + (y-y_i)^2 + (z-z_i)^2 - v^2(t_i-t_0+\Delta_{ip})^2 = 0$$

$$(x-x_j)^2 + (y-y_j)^2 + (z-z_j)^2 - v^2(t_j-t_0+\Delta_{jp})^2 = 0$$

$$(x-x_k)^2 + (y-y_k)^2 + (z-z_k)^2 - v^2(t_k-t_0+\Delta_{kp})^2 = 0$$

En revanche, pour quatre capteurs $A_i$-$A_l$ avec la date d'émission du signal inconnue, le système d'équations à l'itération p devient :

$$f_i - f_{ref} - v^2 (t_i - t_{ref} + \Delta_{ip})^2 = 0$$

$$f_j - f_{ref} - v^2 (t_j - t_{ref} + \Delta_{jp})^2 = 0$$

$$f_k - f_{ref} - v^2 (t_k - t_{ref} + \Delta_{kp})^2 = 0$$

Avantageusement, la résolution du système d'équations est relancée à chaque itération p jusqu'à ce que la somme pour chacun des capteurs, des différentes variations locales du temps de réponse qui ont engendré des solutions, est inférieure à 2% et de préférence inférieure à 1% du temps de réponse initial.

Autrement dit, à chaque itération, on calcule le système d'équations et lorsqu'une solution est trouvée à une itération q, alors les valeurs des deltas $\Delta_{iq}$ $\Delta_{jq}$ $\Delta_{kq}$ utilisés lors de cette itération q sont mémorisées ou enregistrées dans les moyens de stockage 7. On calcule la somme de ces deltas qui ont généré des solutions et on s'arrête lorsque cette somme est nulle ou proche de zéro :

$$\sum_q \Delta_{iq} = 0 \quad \text{ou} \quad \sum_q \Delta_{iq} \leq r_i$$

$$\sum_q \Delta_{jq} = 0 \quad \text{ou} \quad \sum_q \Delta_{jq} \leq r_j$$

$$\sum_q \Delta_{kq} = 0 \quad \text{ou} \quad \sum_q \Delta_{kq} \leq r_k$$

avec $r_i$, $r_j$ et $r_k$ proches de zéro ; plus ces indices seront proches de zéro, plus le résultat sera fiable.

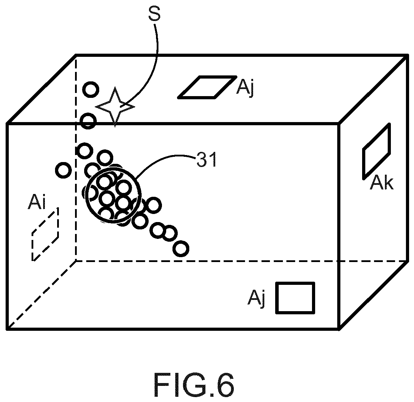

En effet, la Fig. 6 illustre le cas où la somme des valeurs des deltas $\Delta_{iq}$ $\Delta_{jq}$ $\Delta_{kq}$ utilisés est proche de zéro. Dans ce cas, les résultats trouvés (représentés par des petits cercles) sont regroupés et le centre de ces résultats se trouve dans une zone proche de la position réelle de la source S du signal.

Par ailleurs, supposons que le nombre total d'itérations réalisé est P et que le nombre de solutions obtenues est Q, alors le rapport Q/P donne une indication de la précision des résultats trouvés. Par exemple, si Q/P est supérieur à 70%, alors le résultat sera très bon. En revanche, si Q/P est inférieur à 30%, alors le résultat va être très dispersé et dans ce cas, il est préférable de refaire tout le calcul avec des nouvelles valeurs de delta jusqu'à ce que Q (c'est-à-dire, le nombre de systèmes d'équations résolus) soit par exemple supérieur à 50.

Les résultats ou positions $(x_q, y_q, z_q)$ obtenues lors des Q résolutions du système d'équations sont mémorisés dans les moyens de stockage et sont utilisés par les moyens de traitement pour déterminer la localisation de la source du signal.

En particulier, la position de la source des signaux sera proche du centre $(x_c, y_c, z_c)$ de ces points. Ainsi, après l'arrêt des itérations de résolution du système d'équations (c'est-à-dire, après que les critères de précision exposés plus haut sont satisfaisants), les moyens de traitement 3 calculent la localisation $(x_c, y_c, z_c)$ de l'évènement en faisant la moyenne des positions $(x_q, y_q, z_q)$ obtenues lors des différentes résolutions du système d'équations :

$$x_c = \frac{\sum_q x_q}{Q} \qquad y_c = \frac{\sum_q y_q}{Q} \qquad z_c = \frac{\sum_q z_q}{Q}$$

Ainsi, la présente invention permet de donner une solution alternative à une localisation qui n'aurait pas de points d'intersection par la méthode traditionnelle. Cet avantage est notamment très intéressant dans le cas où on ne pourrait pas déplacer les capteurs ou alors dans le cas où la source serait difficile à trouver même en déplaçant les capteurs.

Le procédé selon l'invention peut être utilisé en deuxième recours à une localisation qui aurait échoué et n'est pas incompatible avec la première. Il n'y a donc pas de perte de temps générée par ce procédé dans le cas d'une première localisation réussie, au contraire, il permet une approximation du résultat avant d'avoir, le cas échéant, à changer de place les capteurs de manière "aveugle" si aucun résultat n'avait été trouvé.

Un autre avantage notable apparaît lors de l'utilisation de seulement quatre capteurs, ce qui est fréquent au vu de la complexité technologique des appareils auquel peut être appliquée cette technique. De cette manière, seul un point d'intersection est possible et donc les chances d'obtenir une solution au système d'équations sont très faibles au regard de la précision requise dans ce cas pour la mesure des temps de réponse des capteurs. Le procédé selon l'invention permet alors d'obtenir quand même une zone approximative dans laquelle se situe la source des émissions.

Encore d'autres avantages de la présente invention sont la facilité d'implémentation et la simplicité de la solution.

**Revendications**

1. Procédé de localisation d'un évènement émettant un signal, comportant une mesure des temps de réponse dudit signal par un ensemble de capteurs ($A_i$-$A_m$), et une résolution d'un système d'équations définissant des distances entre lesdits capteurs et ledit évènement (S) en fonction d'une vitesse de propagation dudit signal et d'un décalage desdits temps de réponse par rapport à un temps de référence, **caractérisé en ce que** dans le cas où le système d'équations ne présente pas de solution indiquant la position de l'évènement, le procédé comporte les étapes suivantes :

   - relancer une pluralité de fois la résolution du système d'équations en modifiant à chaque itération le temps de réponse d'au moins un desdits capteurs ($A_i$-$A_m$) selon une augmentation ou une diminution dudit temps de réponse par un pourcentage inférieur à une valeur déterminée, la résolution dudit système d'équations étant relancée à chaque itération jusqu'à ce que la somme pour chacun des capteurs ($A_i$-$A_m$), des différentes augmentations ou diminutions dudit temps de réponse par un pourcentage inférieur à une valeur déterminée qui ont engendré des solutions soit proche de zéro, et
   - déterminer la localisation de l'événement en calculant la moyenne des solutions obtenues lors des résolutions dudit système d'équations.

2. Procédé selon la revendication 1, dans lequel ladite valeur déterminée est de l'ordre de 30% et de préférence de 15%.

3. Procédé selon l'une quelconque des revendications précédentes, dans lequel la résolution du système d'équations est relancée à chaque itération jusqu'à ce que la somme pour chacun des capteurs ($A_i$-$A_m$), des différentes variations locales du temps de réponse qui ont engendré des solutions, soit inférieure à 2% et de préférence inférieure à 1%.

4. Procédé selon l'une quelconque des revendications précédentes, **caractérisé en ce que** dans le cas où la date d'émission dudit signal est inconnue, le temps de référence correspond à un temps de réponse minimal mesuré par l'un des capteurs dudit ensemble de capteurs, et **en ce que** dans le cas où la date d'émission dudit signal est connue, le temps de référence correspond à ladite date d'émission.

5. Procédé selon l'une quelconque des revendications 1 à 4, **caractérisé en ce que** les capteurs ($A_i$-$A_m$) sont positionnés selon un repère de coordonnées bidimensionnelles ou tridimensionnelles de manière à ce que pour au moins un nombre minimal déterminé de capteurs, chaque capteur a au plus une seule coordonnée en commun avec un seul autre capteur.

6. Procédé selon la revendication 5, **caractérisé en ce que** dans le cas où la date d'émission du signal est inconnue, l'ensemble de capteurs comporte un nombre de capteurs strictement supérieur au nombre de coordonnées, et **en ce que** dans le cas où la date d'émission dudit signal est connue, l'ensemble de capteurs comporte un nombre de capteurs supérieur ou égal au nombre de coordonnées.

7. Dispositif de localisation d'un évènement émettant un signal, comportant un ensemble de capteurs ($A_i$-$A_m$) pour mesurer des temps de réponse dudit signal, et des moyens de traitement (3) pour résoudre un système d'équations définissant des distances entre lesdits capteurs et ledit évènement en fonction d'une vitesse de propagation dudit signal et d'un décalage desdits temps de réponse par rapport à un temps de référence, **caractérisé en ce que** le dispositif comporte en outre :

   - des moyens de traitement (3) pour relancer, dans le cas où le système d'équations ne présente pas de solution indiquant la position de l'évènement, une pluralité de fois la résolution du système d'équations en modifiant à chaque fois le temps de réponse d'au moins un desdits capteurs selon une augmentation ou une diminution dudit temps de réponse par un pourcentage inférieur à une valeur déterminée, la résolution dudit système d'équations étant relancée à chaque itération jusqu'à ce que la somme pour chacun des capteurs ($A_i$-$A_m$), des différentes augmentations ou diminutions dudit temps de réponse par un pourcentage inférieur à une valeur déterminée qui ont engendré des solutions soit proche de zéro, et

- des moyens de traitement (3) pour déterminer la localisation de l'évènement en calculant la moyenne des solutions obtenues lors des résolutions dudit système d'équations.

8. Dispositif selon la revendication 7, **caractérisé en ce que** l'ensemble des capteurs comporte des capteurs à ultra haute fréquence et/ou des capteurs à ultrasons.

9. Programme d'ordinateur comportant des instructions pour la mise en oeuvre du procédé de localisation selon l'une quelconque des revendications 1 à 6 lorsqu'il est exécuté par des moyens de traitement.

**Patentansprüche**

1. Verfahren zur Lokalisierung eines Ereignisses, von dem ein Signal ausgesendet wird, umfassend eine Messung der Antwortzeiten des Signales durch eine Sensoranordnung ($A_i$-$A_m$), und eine Auflösung eines Gleichungssystems, mit dem Entfernungen zwischen den Sensoren und dem Ereignis (S) in Abhängigkeit von einer Ausbreitungsgeschwindigkeit des Signales und eines Versatzes der Antwortzeiten im Verhältnis zu einer Referenzzeit definiert werden, **dadurch gekennzeichnet, dass** in dem Fall, in welchem das Gleichungssystem keine Lösung aufweist, welche die Position des Ereignisses angibt, das Verfahren die nachfolgenden Schritte umfasst:

   - erneutes mehrmaliges Durchführen der Auflösung des Gleichungssystems, indem bei jeder Wiederholung die Antwortzeit von mindestens einem der Sensoren ($A_i$-Am) gemäß einer Erhöhung oder einer Verminderung der Antwortzeit um einen Prozentsatz modifiziert wird, der niedriger als ein bestimmter Wert ist, wobei die Auflösung des Gleichungssystems bei jeder Wiederholung solange erneut durchgeführt wird, bis die Summe für jeden der Sensoren ($A_i$-$A_m$) der verschiedenen Erhöhungen oder Verminderungen der Antwortzeit um einen Prozentsatz, der niedriger als ein bestimmter Wert ist, welche Lösungen hervorgebracht haben, in der Nähe von Null liegt, und
   - Bestimmen der Lokalisierung des Ereignisses, indem der Durschnitt der Lösungen berechnet wird, die während der Auflösungen des Gleichungssystems erhalten werden.

2. Verfahren nach Anspruch 1, wobei der Wert, der bestimmt wird, in der Größenordnung von 30 % und vorzugsweise von 15 % liegt.

3. Verfahren nach einem der vorhergehenden Ansprüche, wobei die Auflösung des Gleichungssystems bei jeder Wiederholung solange erneut durchgeführt wird, bis die Summe für jeden der Sensoren ($A_i$-$A_m$) der verschiedenen örtlichen Variationen der Antwortzeit, welche die Lösungen hervorgebracht haben, niedriger als 2 % und vorzugsweise niedriger als 1 % ist.

4. Verfahren nach einem der vorhergehenden Ansprüche, **dadurch gekennzeichnet, dass** in dem Fall, in welchem das Ausgabedatum des Signales unbekannt ist, die Referenzzeit einer minimalen Antwortzeit entspricht, die durch einen der Sensoren der Sensoranordnung gemessen wird, und dadurch, dass, in dem Fall, in welchem das Ausgabedatum des Signales unbekannt ist, die Referenzzeit dem Ausgabedatum entspricht.

5. Verfahren nach einem der Ansprüche 1 bis 4, **dadurch gekennzeichnet, dass** die Sensoren ($A_i$-$A_m$) gemäß einer Markierung zweidimensionaler oder dreidimensionaler Koordinaten dergestalt positioniert sind, dass für mindestens eine minimale bestimmte Anzahl an Sensoren, jeder Sensor höchstens eine einzige gemeinsame Koordinate mit einem einzigen anderen Sensor aufweist.

6. Verfahren nach Anspruch 5, **dadurch gekennzeichnet, dass** in dem Fall, in welchem das Ausgabedatum des Signales unbekannt ist, die Sensoranordnung eine Anzahl an Sensoren umfasst, die unbedingt höher als die Anzahl an Koordinaten ist, und dadurch, dass, in dem Fall, in welchem das Ausgabedatum des Signales bekannt ist, die Sensoranordnung eine Anzahl an Sensoren umfasst, die höher oder gleich der Anzahl an Koordinaten ist.

7. Vorrichtung zur Lokalisierung eines Ereignisses, von dem ein Signal ausgesendet wird, umfassend eine Sensoranordnung ($A_i$-$A_m$), um Antwortzeiten des Signales zu messen, und Verarbeitungsmittel (3), um ein Gleichungssystem aufzulösen, mit dem Entfernungen zwischen den Sensoren und dem Ereignis in Abhängigkeit von einer Ausbreitungsgeschwindigkeit des Signales und eines Versatzes der Antwortzeiten im Verhältnis zu einer Referenzzeit definiert werden, **dadurch gekennzeichnet, dass** die Vorrichtung außerdem Folgendes umfasst:

   - Verarbeitungsmittel (3), um in dem Fall, in welchem das Gleichungssystem keine Lösung aufweist, welche die Position des Ereignisses angibt, die Auflösung des Gleichungssystems mehrmals erneut durchzuführen, indem jedes Mal die Antwortzeit von mindestens einem der Sensoren gemäß einer Erhöhung oder einer Verminderung der Antwortzeit um einen Prozentsatz modifiziert wird, der niedriger als ein bestimmter Wert ist, wobei die Auflösung des Gleichungssystems bei jeder Wiederholung solange erneut durchgeführt wird, bis die Summe für jeden der Sensoren (A$_i$-A$_m$) der verschiedenen Erhöhungen oder Verminderungen der Antwortzeit um einen Prozentsatz, der niedriger als ein bestimmter Wert ist, welche Lösungen hervorgebracht haben, in der Nähe von Null liegt, und

- Verarbeitungsmittel (3), um die Lokalisierung des Ereignisses zu bestimmen, indem der Durchschnitt der Lösungen berechnet wird, die während der Auflösungen des Gleichungssystems erhalten werden.

8. Vorrichtung nach Anspruch 7, **dadurch gekennzeichnet, dass** die Anordnung der Sensoren Ultrahochfrequenzsensoren und/oder Ultraschallsensoren umfasst.

9. Computerprogramm, Anweisungen umfassend, um das Verfahren zur Lokalisierung nach einem der Ansprüche 1 bis 6 anzuwenden, wenn es durch die Verarbeitungsmittel ausgeführt wird.

**Claims**

1. Method for locating an event transmitting a signal, including a measurement of the response times of said signal by a set of sensors (A$_i$-A$_m$), and a solution of a system of equations defining distances between said sensors and said event (S) as a function of a speed of propagation of said signal and of an offset of said response times relative to a reference time, **characterised in that**, if the system of equations has no solution indicating the position of the event, the method includes the following steps:

- recommencing several times the solution of the system of equations, by modifying with each iteration the response time of at least one of said sensors (A$_i$-A$_m$) according to an increase or decrease of said response time by a percentage less than a determined value, where the solution of said system of equations is recommenced with each iteration, until the sum for each of the sensors (A$_i$-A$_m$), of the different increases or decreases of said response time by a percentage less than a determined value, is close to zero, and
- determining the location of the event by calculating the average of the solutions obtained while solving said system of equations.

2. Method according to claim 1, wherein said determined value is around 30% and preferably 15%.

3. Method according to any one of the preceding claims, wherein the solution of the system of equations is recommenced with each iteration until the sum for each of the sensors (A$_i$-A$_m$) of the different local variations of the response time which have produced solutions, is less than 2% and preferably less than 1%.

4. Method according to any one of the preceding claims, **characterised in that**, if the transmission date of said signal is unknown, the reference time corresponds to a minimal response time measured by one of the sensors of said set of sensors, and **in that**, if the transmission date of said signal is known, the reference time corresponds to said transmission date.

5. Method according to any one of claims 1 to 4, **characterised in that** the sensors (A$_i$-A$_m$) are positioned according to a reference frame of two-dimensional or three-dimensional coordinates such that, for at least a determined minimal number of sensors, each sensor has at most a single coordinate in common with a single other sensor.

6. Method according to claim 5, **characterised in that**, if the transmission date of the signal is unknown, the set of sensors includes a number of sensors which is strictly greater than the number of coordinates, and **in that**, if the transmission date of said signal is known, the set of sensors includes a number of sensors which is greater than or equal to the number of coordinates.

7. A device for locating an event transmitting a signal, including a set of sensors (A$_i$-A$_m$) to measure the response times of said signal, and processing means (3) to solve a system of equations defining distances between said sensors and said event as a function of a speed of propagation of said signal and of an offset of said response times relative to a reference time, **characterised in that** the device also includes:

- processing means (3) to recommence, if the system of equations does not have a solution indicating the position of the event, several times the solution of the system of equations, each time modifying the response time of at least one of said sensors, through an increase or decrease of said response time by a percentage of less than a determined value, where the solution of said system of equations is recommenced with each iteration, until the sum for each of the sensors ($A_i$-$A_m$) of the different increases or decreases of said response time by a percentage less than a determined value is close to zero, and
- processing means (3) for determining the location of the event by calculating the average of the solutions obtained while solving said system of equations.

8. Device according to claim 7, **characterised in that** the set of sensors includes ultrahigh-frequency sensors and/or ultrasonic sensors.

9. Computer program including instructions for implementing the location method according to any one of claims 1 to 6 when it is executed by the processing means.

FIG.1

EP 2 758 795 B1

FIG.2

FIG.3

FIG.4

EP 2 758 795 B1

FIG.5

EP 2 758 795 B1

FIG.6

**RÉFÉRENCES CITÉES DANS LA DESCRIPTION**

**Littérature non-brevet citée dans la description**

- **LUO et al.** Study on Partial Discharge Localization by Ultrasonic Measuring in Power Transformer Based on Particle Swarm Optimization. *Proc. of Int. Conf. on High Voltage Engineering and Application,* 2008